# EUROPEAN PATENT APPLICATION

(11) **EP 4 831 740 A1**
(43) Date of publication of application: **28.10.2026**
(21) Application number: 25916632.0
(22) Date of filing: 05.11.2025
(51) Int. Cl.: G03F 7/105, G03F 7/027, G03F 7/004, C09K 11/02, C09K 11/66

(54) **QUANTUM DOT-CONTAINING PHOTOSENSITIVE COMPOSITION, QUANTUM DOT OPTICAL SHEET, BACKLIGHT UNIT, AND DISPLAY DEVICE**

(30) Priority: 03.01.2025 KR 20250000672
(71) Applicant: Hansol Chemical Co., Ltd, Seoul 06169 (KR)
(72) Inventor: NAM, Kyoung Mo, Wanju-gun, Jeonbuk-do 55321 (KR); YUN, Mi Hee, Wanju-gun, Jeonbuk-do 55321 (KR); BAE, Yun Ju, Wanju-gun, Jeonbuk-do 55321 (KR); KIM, Gil Ran, Wanju-gun, Jeonbuk-do 55321 (KR); JANG, Eun Pyo, Wanju-gun, Jeonbuk-do 55321 (KR); PARK, Gyu Ri, Wanju-gun, Jeonbuk-do 55321 (KR); NOH, Jae Hong, Wanju-gun, Jeonbuk-do 55321 (KR); KIM, Kyung Nam, Wanju-gun, Jeonbuk-do 55321 (KR)
(74) Representative: Cabinet Beau de Loménie
(86) International application number: PCT/KR2025/018030
(87) International publication number: WO 2026/146842

(57) **Abstract**

A quantum dot-containing photosensitive composition, a quantum dot optical sheet, a backlight unit, and a display device are disclosed. The quantum dot-containing photosensitive composition includes a component capable of forming a polymer matrix having excellent compatibility with perovskite quantum dots and a light diffusing agent that does not impair stability of the perovskite quantum dots, whereby the perovskite quantum dots can maintain excellent optical properties and can exhibit further improved initial luminance and photostability by preventing degradation of the perovskite quantum dots due to external stimuli, thereby providing high quality backlight units and display devices.

## Description

### [Technical Field]

The present invention relates to a quantum dot-containing photosensitive composition, a quantum dot optical sheet including a cured product thereof, and a backlight unit and display device including the quantum dot optical sheet.

### [Background Art]

Quantum dots (QDs), also known as semiconductor nanocrystals, can emit various colors through generation of light with different wavelengths depending on particle size and have advantages of better color purity and photostability than typical light emitting materials, thereby attracting attention as a material for next generation high image-quality displays.

Perovskites are materials with a unique crystal structure and a wide range of physical and chemical properties. Particularly, a halide-based perovskite, such as CsPbBr₃, can produce more vibrant and colorful hues. However, since perovskites can be easily degraded due to sensitivity to external stimuli, such as light, heat, moisture, and the like, the perovskites can suffer from significant deterioration in stability and performance due to physical and chemical deformation. In addition, if other components, for example, a polymer matrix and/or a light diffusing agent, contained in a quantum dot optical sheet are poorly compatible or incompatible with the perovskites, there can be a problem of degradation in properties, such as luminance, luminous efficacy, and color purity.

Therefore, in order to make perovskite quantum dots practical as a display material, it is necessary to improve stability of the perovskite quantum dots so as to maintain long-term performance without degradation in an external environment and there is a need for development of an optimal combination of a polymer matrix and a diffusing agent that can maximize initial optical properties of the perovskite quantum dots.

### [Disclosure]

### [Technical Problem]

The present invention has been conceived to solve the above problems in the art and it is an object of the present invention to provide a quantum dot-containing photosensitive composition that can maintain excellent optical properties by preventing degradation of perovskite quantum dots due to an external environment.

It is another object of the present invention to provide a quantum dot-containing photosensitive composition that employs a light diffusing agent having excellent compatibility with perovskite quantum dots to achieve further improvement in initial luminance while exhibiting excellent photostability even when exposed to blue light for a long period of time.

It is a further object of the present invention to provide a quantum dot optical sheet formed of the quantum dot-containing photosensitive composition to have excellent color purity, and a backlight unit and display device including the same.

However, it should be understood that the present invention is not limited to the above objects, and the above and other objects will become apparent to those skilled in the art from the following description.

### [Technical Solution]

In accordance with one aspect of the present invention, there is provided a quantum dot-containing photosensitive composition including: perovskite quantum dots; a photopolymerizable monomer; a photoinitiator; and a light diffusing agent, wherein the light diffusing agent includes boron nitride (BN).

In the quantum dot-containing photosensitive composition, the perovskite quantum dots may be halide-based perovskite quantum dots.

In the quantum dot-containing photosensitive composition, the halide-based perovskite quantum dots may be a compound represented by Formula 1.

[Formula 1] ABX₃

(In Formula 1, A is formamidinium (FA), methylammonium (MA), FA_{X}MA_{(1-X)} (0<X<1), N⁺(R¹)₄, Na, K, Rb, Cs, Fr, or Ti, where R¹ is a C₁ to C₅ alkyl group, phenyl group, alkylphenyl group, or alkoxyphenyl group; B is Pb, Mn, Cu, Ga, Ge, In, Al, Sb, Bi, Po, Sn, Eu, Yb, Ni, Co, Fe, Cr, Pd, Cd, Ca, or Sr; and X is F, Cl, Br, I, or a combination thereof.)

In the quantum dot-containing photosensitive composition, the perovskite quantum dots may have a ligand layer on a surface thereof, the ligand layer including at least one selected from the group consisting of an amine-based ligand, an organic acid-based ligand, and an organoammonium-based ligand.

In the quantum dot-containing photosensitive composition, the photopolymerizable monomer may include at least one selected from the group consisting of a bisphenol-based monomer, a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

In the quantum dot-containing photosensitive composition, the photopolymerizable monomer may include: a bisphenol-based monomer; and at least one selected from the group consisting of a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

In the quantum dot-containing photosensitive composition, the boron nitride may be hexagonal boron nitride.

In the quantum dot-containing photosensitive composition, the light diffusing agent may be present in an amount of 0.5 wt% to 10 wt%, based on the total weight of the quantum dot-containing photosensitive composition.

In accordance with another aspect of the present invention, there is provided a quantum dot optical sheet including a cured product of the quantum dot-containing photosensitive composition.

In accordance with a further aspect of the present invention, there is provided a backlight unit including the quantum dot optical sheet.

In accordance with yet another aspect of the present invention, there is provided a display device including the backlight unit.

### [Advantageous Effects]

A quantum dot-containing photosensitive composition according to the present invention includes components capable of forming a polymer matrix having excellent compatibility with perovskite quantum dots, thereby preventing degradation of perovskite quantum dots due to an external environment while exhibiting excellent optical properties.

In addition, the quantum dot-containing photosensitive composition according to the present invention includes a light diffusing agent that does not interfere with stability of the perovskite quantum dots, thereby further improving initial luminance of the quantum dot optical sheet while exhibiting excellent photostability even when exposed to blue light for a long period of time.

Furthermore, the quantum dot-containing photosensitive composition according to the present invention can be effectively applied to manufacture of a quantum dot optical sheet exhibiting excellent color purity, thereby providing high-quality backlight units and display devices.

### [Description of Drawings]

FIG. 1 is a graph depicting measurement results of initial luminance (Lm1) and luminance after light exposure (Lm2) for quantum dot optical sheets prepared in Examples 1 to 2 and Comparative Examples 1 to 7.
FIG. 2 is a graph depicting analysis results of luminescence spectra of quantum dot optical sheets prepared in Examples 1, 2 and Comparative Example 1.
FIG. 3 is a graph depicting analysis results of luminescence spectra of quantum dot optical sheets prepared in Examples 1 and 3.

### [Best Mode]

Unless otherwise defined herein, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the related art and should not be interpreted in an idealized or overly formal sense, unless clearly defined herein.

In addition, as used herein, the terms "comprises," "comprising," "includes," and/or "including" specify the presence of stated elements and/or steps, but do not preclude the presence or addition of at least one other element and/or step.

In addition, the singular forms "a," "an" and "the" are intended to include the plural forms as well, unless context clearly indicates otherwise. For example, as used herein, "light diffusion layer" may refer to at least one light diffusion layer among a first light diffusion layer and a second light diffusion layer.

In addition, spatially relative terms, such as "under," "lower surface," "below," "on," "upper surface," "above," and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the sheet in the drawings is turned over, elements described as "under" or "below" other elements or features would then be placed "on" or "above" the other elements or features. Thus, the exemplary term "under" or "below" can encompass both an orientation of above and below.

In addition, as used herein, the terms "monomeric product" and "monomer" have the same meaning. In the context of the invention, a monomer is distinguished from oligomers and polymers and is a compound having a weight average molecular weight of 1,000 or less.

In addition, as used herein, "(meth)acrylate" refers to acrylate and methacrylate, "(meth)acryl" refers to acryl and methacryl, and "(meth)acryloyl" refers to acryloyl and methacryloyl.

### <Quantum dot-containing photosensitive composition>

The quantum dot-containing photosensitive composition according to the present invention includes perovskite quantum dots, a photopolymerizable monomer, a photoinitiator, and a light diffusing agent, and may further include other additives, as needed.

### Perovskite quantum dot

The perovskite quantum dots generally refer to nanometer-scale crystal particles with a unique perovskite crystal structure and are characterized in that, based on quantum confinement effects, a luminescence wavelength band thereof can be controlled by adjusting the particle size of the perovskite quantum dots.

The perovskite quantum dots may be halide-based perovskites, preferably a compound represented by Formula 1.

[Formula 1] ABX₃

In Formula 1, A is formamidinium (FA), methylammonium (MA), FA_{X}MA_{(1-X)} (0<X<1), N⁺(R¹)₄, Na, K, Rb, Cs, Fr, or Ti, where R¹ is a C₁ to C₅ alkyl group, phenyl group, alkylphenyl group, or alkoxyphenyl group. In one embodiment, A may be Cs, without being limited thereto.

Further, in Formula 1, B may be Pb, Mn, Cu, Ga, Ge, In, Al, Sb, Bi, Po, Sn, Eu, Yb, Ni, Co, Fe, Cr, Pd, Cd, Ca, or Sr. In one embodiment, B may be Pb, without being limited thereto.

Further, in Formula 1, X may be F, Cl, Br, I, or a combination thereof. In one embodiment, X may be Br, without being limited thereto.

The perovskite quantum dots may have a diameter of 1 nm to 200 nm, preferably 3 nm to 100 nm, more preferably 5 nm to 50 nm.

The perovskite quantum dots may be present in an amount of 0.1 wt% to 50 wt%, preferably 1 wt% to 30 wt%, based on the total weight of the quantum dot-containing photosensitive composition.

The perovskite quantum dots may have a ligand layer on a surface thereof. Ligands contained in the ligand layer serve to modify the surfaces of the perovskite quantum dots, whereby the perovskite quantum dots subjected to surface modification with suitable ligands can have improved dispersion stability and allow the size of nanocrystals to be controlled by controlling a crystallization rate.

The ligand layer may include at least one selected from the group consisting of an amine-based ligand, an organic acid-based ligand, and an organoammonium-based ligand.

The amine-based ligand may include at least one selected from the group consisting of hexylamine, octylamine, decylamine, oleylamine, N,N-diisopropylethylamine, ethylenediamine, hexamethylenetetramine, methylamine, N,N,N,N-tetramethylenethylenediamine, triethylamine, diethanolamine, 2,2-(ethylenedioxy)bis-(ethylamine), 2-methyl-1,5-pentanediamine, 3-methoxytriphenylamine, 1,4-phenylenediamine, N,N,N,N-pentamethyldiethylenetriamine, triethylenetetramine, diethylamine, and ethylenediamine.

The organic acid-based ligand may include at least one selected from the group consisting of 4,4'-azobis(4-cyanovaleric acid), acetic acid, 5-aminosalicylic acid, acrylic acid, L-aspartic acid, 6-bromohexanoic acid, bromoacetic acid, dichloroacetic acid, ethylenediaminetetraacetic acid, isobutyric acid, itaconic acid, maleic acid, 4-maleimidobutyric acid, L-malic acid, 4-nitrobenzoic acid, 1-pyrenecarboxylic acid, and oleic acid.

The organoammonium-based ligand may include at least one selected from the group consisting of didecyldimethyl ammonium bromide (DDeAB), dioctyldimethyl ammonium bromide (DOAB), didodecyldimethyl ammonium bromide (DDAB), methyltrioctylammonium bromide (TrOAB), tetraoctylammonium bromide (TeOAB), and ditetradecyldimethyl ammonium bromide (DTAB), preferably didodecyldimethyl ammonium bromide (DDAB).

### Photopolymerizable monomer

The photopolymerizable monomer refers to a compound capable of being polymerized through action of a photoinitiator described below, and forms a polymer matrix in a quantum dot optical sheet.

The photopolymerizable monomer may include at least one selected from the group consisting of a bisphenol-based monomer, a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

The photopolymerizable monomer may essentially include a bisphenol-based monomer and may further include at least one selected from the group consisting of a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

The bisphenol-based monomer may include bis(4-hydroxyphenyl)methane, bis(4-hydroxyphenyl)ether, bis(4-hydroxyphenyl)sulfone, bis(4-hydroxyphenyl)sulfoxide, bis(4-hydroxyphenyl)sulfide, bis(4-hydroxyphenyl)ketone, 1,1-bis(4-hydroxyphenyl)ethane, 2,2-bis(4-hydroxyphenyl)propane (bisphenol A), 2,2-bis(4-hydroxyphenyl)butane, 1,1-bis(4-hydroxyphenyl)cyclohexane (bisphenol Z), 2,2-bis(4-hydroxy-3,5-dibromophenyl)propane, 2,2-bis(4-hydroxy-3,5-dichlorophenyl)propane, 2,2-bis(4-hydroxy-3-bromophenyl)propane, 2,2-bis(4-hydroxy-3-chlorophenyl)propane, 2,2-bis(4-hydroxy-3-methylphenyl)propane, 2,2-bis(4-hydroxy-3,5-dimethylphenyl)propane, 1,1-bis(4-hydroxyphenyl)-1-phenylethane, bis(4-hydroxyphenyl)diphenylmethane, α,ω-bis[3-(o-hydroxyphenyl)propyl]polydimethylsiloxane, ethoxylated bisphenol A di(meth)acrylate, and the like, without being limited thereto. Preferably, the bisphenol-based monomer includes ethoxylated bisphenol A di(meth)acrylate.

The monofunctional (meth)acrylate monomer may include methyl (meth)acrylate, ethyl (meth)acrylate, propyl (meth)acrylate, butyl (meth)acrylate, hexyl (meth)acrylate, cyclohexyl (meth)acrylate, 2-ethylhexyl (meth)acrylate, lauryl (meth)acrylate, stearyl (meth)acrylate, octadecyl (meth)acrylate, isooctyl (meth)acrylate, isononyl (meth)acrylate, isodecyl (meth)acrylate, isobornyl (meth)acrylate, and the like, without being limited thereto.

The bifunctional (meth)acrylate monomer may include ethylene glycol di(meth)acrylate, propylene glycol di(meth)acrylate, polyolefin glycol di(meth)acrylate, ethoxylated polypropylene glycol di(meth)acrylate, 2-hydroxy-3-acryloyloxypropylmethacrylate, 2-hydroxy-1,3-dimethacryloxypropane, dioxane glycol di(meth)acrylate, tricyclodecanedimethanol di(meth)acrylate, 1,4-butanediol di(meth)acrylate, glycerin di(meth)acrylate, 1,6-hexanediol di(meth)acrylate, 1,9-nonanediol di(meth)acrylate, 1,10-decanediol di(meth)acrylate, neopentyl glycol di(meth)acrylate, 2-methyl-1,8-octanediol di(meth)acrylate, butyl ethylpropanediol di(meth)acrylate, 3-methyl-1,5-pentanediol di(meth)acrylate, and the like, without being limited thereto.

The trifunctional (meth)acrylate monomer may include ethoxylated glycerol tri(meth)acrylate, trimethylolpropane tri(meth)acrylate, ethoxylated trimethylolpropane tri(meth)acrylate, propoxylated trimethylolpropane tri(meth)acrylate, pentaerythritol tri(meth)acrylate, and the like, without being limited thereto.

The tetra- or higher functional (meth)acrylate monomer may include tetrafunctional (meth)acrylate monomers, such as pentaerythritol tetra(meth)acrylate, ditrimethylolpropane tetra(meth)acrylate, ethoxylated pentaerythritol tetra(meth)acrylate, and the like; pentafunctional (meth)acrylate monomers, such as dipentaerythritol pentaacrylate, propionic acid-modified dipentaerythritol pentaacrylate, dipentaerythritol pentamethacrylate, propionic acid-modified dipentaerythritol pentamethacrylate, and the like; hexafunctional (meth)acrylate monomers, such as dipentaerythritol hexaacrylate, caprolactone-modified dipentaerythritol hexaacrylate, dipentaerythritol hexamethacrylate, caprolactone-modified dipentaerythritol hexamethacrylate, and the like, without being limited thereto.

The alicyclic (meth)acrylate monomer may include cyclopentyl (meth)acrylate, cyclohexyl (meth)acrylate, 2-methylcyclohexyl (meth)acrylate, tricyclo[5.2.1.0^{2,6}]decan-8-yl(meth)acrylate, dicyclopentanyl (meth)acrylate, 2-dicyclopentanyloxyethyl (meth)acrylate, isobornyl (meth)acrylate, and the like, without being limited thereto. Preferably, the alicyclic (meth)acrylate monomer includes dicyclopentanyl(meth)acrylate.

The monomer having at least two thiol groups at the terminal ends thereof includes pentaerythritol tetrakis(2-mercaptoacetate), pentaerythritol tetrakis(3-mercaptopropionate), 1,2-ethanedithiol, pentaerythritol tetrakis(mercaptopropionate), pentaerythritol tetrakis(thioglycolate), trimethylolpropane tris(2-mercaptoacetate), trimethylolpropane tris(3-mercaptopropionate), and the like, without being limited thereto. Preferably, the monomer having at least two thiol groups at the terminal ends thereof includes pentaerythritol tetrakis(3-mercaptopropionate).

The photopolymerizable monomer may be present in an amount of 30 wt% to 95 wt%, preferably 40 to 90 wt%, based on the total weight of the quantum dot-containing photosensitive composition.

### Photoinitiator

The photoinitiator serves to initiate photopolymerization through excitation by light, such as ultraviolet (UV) light, and may be any typical photoinitiator used in the art.

In one embodiment, the photoinitiator may include at least one selected from the group consisting of a phosphine oxide compound, an acetophenone compound, a benzophenone compound, a triazine compound, a biimidazole compound, an oxime compound, and a thioxanthone compound.

Examples of the phosphine oxide compound may include bis(2,4,6-trimethylbenzoyl)phenylphosphine oxide, trimethylbenzoylphenylphosphine oxide, ethyl(2,4,6-trimethylbenzoyl)phenylphosphinate, diphenyl(2,4,6-trimethylbenzoyl)phosphine oxide, and the like. As a commercially available phosphine oxide compound, TPO-L (IGM) may be used.

Examples of the acetophenone compound may include diethoxyacetophenone, 2-hydroxy-2-methyl-1-phenylpropan-1-one, benzyl dimethyl ketal, 2-hydroxy-1-[4-(2-hydroxyethoxy)phenyl]-2-methylpropan-1-one, 1-hydroxycyclohexylphenylketone, 2-methyl-1-(4-methylthiophenyl)-2-morpholinopropan-1-one, 2-benzyl-2-dimethylamino-1-(4-morpholinophenyl)butan-1-one, 2-hydroxy-2-methyl-1-[4-(1-methylvinyl)phenyl]propan-1-one, 2-(4-methylbenzyl)-2-(dimethylamino)-1-(4-morpholinophenyl)butan-1-one, and the like.

Examples of the benzophenone compound may include benzophenone, methyl o-benzoylbenzoate, 4-phenylbenzophenone, 4-benzoyl-4'-methyldiphenylsulfide, 3,3',4,4'-tetra(tert-butylperoxycarbonyl)benzophenone, 2,4,6-trimethylbenzophenone, and the like.

Examples of the triazine compound may include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, 2,4-bis(trichloromethyl)-6-[2-(3,4-dimethoxyphenyl)ethenyl]-1,3,5-triazine, and the like.

Examples of the biimidazole compound may include 2,2'-bis(2-chlorophenyl)-4,4',5,5'-tetraphenylbiimidazole, 2,2'-bis(2,3-dichlorophenyl)-4,4',5,5'-tetraphenylbiimidazole, 2,2'-bis(2-chlorophenyl)-4,4',5,5'-tetra(alkoxyphenyl)biimidazole, 2,2'-bis(2-chlorophenyl)-4,4',5,5'-tetra(trialkoxyphenyl)biimidazole, 2,2-bis(2,6-dichlorophenyl)-4,4',5,5'-tetraphenyl-1,2'-biimidazole, biimidazole compounds in which a phenyl group at the 4,4',5,5' position is substituted with a carboalkoxy group, and the like. Among these compounds, 2,2'-bis(2-chlorophenyl)-4,4',5,5'-tetraphenylbiimidazole, 2,2'-bis(2,3-dichlorophenyl)-4,4',5,5'-tetraphenylbiimidazole, and 2,2-bis(2,6-dichlorophenyl)-4,4',5,5'-tetraphenyl-1,2'-biimidazole are preferably used.

Examples of the oxime compound may include o-ethoxycarbonyl-α-oxyimino-1-phenylpropan-1-one, 2-((benzoyloxy)imino)-1-(4-(phenylthio)phenyl)octan-1-one, and the like. As a commercially available oxime compound, Irgacure OXE 01 and OXE 02 (BASF) may be used.

Examples of the thioxanthone compound may include 2-isopropylthioxanthone, 2,4-diethylthioxanthone, 2,4-dichlorothioxanthone, 1-chloro-4-propoxythioxanthone, and the like.

The photoinitiator may be present in an amount of 0.01 wt% to 10 wt%, preferably 0.1 wt% to 5 wt%, based on the total weight of the quantum dot-containing photosensitive composition.

### Light diffusing agent

The light diffusing agent serves to increase the overall photoconversion rate of an optical sheet containing the perovskite quantum dots by increasing an optical path of light emitted from a light source. However, a typical metal oxide-based light diffusing agent can significantly deteriorate optical characteristics of the perovskite quantum dots due to a unique crystal structure of the perovskite quantum dots.

The quantum dot-containing photosensitive composition according to the present invention includes boron nitride (BN) as a light diffusing agent to allow increase in overall photoconversion rate of the optical sheet without deterioration in optical properties of the perovskite quantum dots.

The boron nitride is a compound consisting of boron atoms and nitrogen atoms, and may include at least one selected from the group consisting of plate shaped hexagonal boron nitride (h-BN), diamond shaped cubic boron nitride (c-BN), amorphous boron nitride (a-BN), and wurtzite boron nitride (w-BN), preferably hexagonal boron nitride (h-BN).

In one embodiment, the quantum dot-containing photosensitive composition may be free from a metal oxide. In the quantum dot-containing photosensitive composition, the metal oxide can cause significant deterioration in optical property and stability of the perovskite quantum dots.

More specifically, the quantum dot-containing photosensitive composition according to the present invention may be free from ZnO, SiO₂, Al₂O₃ or TiO₂. Preferably, the quantum dot-containing photosensitive composition is free from ZnO, SiO₂, Al₂O₃, TiO₂, ZrO₂, CaCO₃, BaSO₄, BaTiO₃, Ta₂O₅, Ti₃O₅, ITO, IZO, ATO, ZnO-Al, Nb₂O₃, SnO, or MgO.

The light diffusing agent may be present in an amount of 0.5 wt% to 10 wt%, preferably 1 wt% to 5 wt%, based on the total weight of the quantum dot-containing photosensitive composition.

### Other additives

In addition to the aforementioned components, the quantum dot-containing photosensitive composition may include additives known in the art, as needed. Here, the content of each additive may be suitably adjusted within the range known in the art.

Examples of the additives include a silane compound, a siloxane compound, an antioxidant, a polymerization inhibitor, a lubricant, a surface modifier, surfactants, an adhesion enhancer, a defoaming agent, a slip agent, a solvent, a wetting agent, a light stabilizer, a stain inhibitor, a softener, a thickener, a polymer, and the like. These additives may be used alone or as a mixture thereof.

The silane compound serves to impart adhesion to the matrix and the siloxane compound serves to impart wetting properties. The silane compound and the siloxane compound may be selected from typical compounds known in the art.

The antioxidant serves to inhibit discoloration by heat or light irradiation and discoloration due to various oxidizing gases, such as ozone, reactive oxygen species, NOx, SOx (where x is an integer), and the like. According to the present invention, the antioxidant can prevent discoloration of the matrix or can suppress reduction in film thickness due to decomposition. Examples of the antioxidant include hydrazides, hindered amine antioxidants, nitrogen-containing heterocyclic mercapto compounds, thioether antioxidants, hindered phenol antioxidants, ascorbic acid, zinc sulfate, thiocyanates, thiourea derivatives, sugars, nitrites, sulfites, thiosulfates, hydroxylamine derivatives, and the like.

The leveling agent may be used to further enhance adhesion of the composition by leveling the quantum dot-containing photosensitive composition such that the quantum dot-containing photosensitive composition can be coated flatly and evenly. The leveling agent may include an acrylic compound, a silicone compound, or a mixture thereof. For example, the leveling agent may include polyether-modified polydimethylsiloxane containing a (meth)acryloyl group added to the polyether chain thereof.

The surfactant may be used for miscibility and coating uniformity of the quantum dot-containing photosensitive composition. The surfactant may be selected from among typical cationic, anionic, amphoteric, and non-ionic surfactants known in the art. For example, the surfactant may include at least one selected from among a fluorinated surfactant, a silicone surfactant, and a fluorosilicone surfactant.

The light stabilizer is a UV absorbent and has an effect of increasing weather resistance of the matrix. The softener serves to mitigate occurrence of cracks in the dried polymer matrix and can improve impact resistance and flexural resistance by mitigating occurrence of cracks within a cured matrix.

### <Quantum dot optical sheet, backlight unit, and display device>

The present invention provides a quantum dot optical sheet including a cured product of the quantum dot-containing photosensitive composition.

According to one embodiment, the quantum dot optical sheet may include: a first barrier layer; a second barrier layer disposed opposite the first barrier layer; and a photoconversion layer interposed between the first and second barrier layers, wherein the photoconversion layer includes a cured product of the quantum dot-containing photosensitive composition according to the present invention.

The barrier layer may be a layer for protecting the photoconversion layer containing the perovskite quantum dots from an external environment and may be formed, attached or stacked in direct contact with the photoconversion layer. The barrier layer may include a polymer and/or additives that have barrier properties against moisture and oxygen while exhibiting excellent heat resistance, and may be any type of barrier film well-known in the art.

The barrier layer may have any thickness so long as the barrier layer is capable of protecting the photoconversion layer from an external environment. For example, the barrier layer may have a thickness of 10 µm to 100 µm. Within this range, the barrier layer can ensure sufficient barrier characteristics without curling after curing, thereby preventing defects caused by curling.

In one embodiment, the quantum dot optical sheet may be a green quantum dot optical sheet that emits green light upon receiving blue light. For example, the blue light may be light having a wavelength of 448 nm to 450 nm and the green light may be light having a wavelength of 519 nm to 522 nm, without being limited thereto.

The green quantum dot optical sheet may have a full width at half maximum (FWHM) of 22 nm or less, preferably 21 nm or less, more preferably 20 nm or less, in the emission spectrum of green light.

In one embodiment, the photoconversion layer may include a first photoconversion layer that emits green light upon receiving blue light, and a second photoconversion layer that emits red light upon receiving blue light, in which the first photoconversion layer includes a cured product of the quantum dot-containing photosensitive composition according to the present invention.

For the quantum dot optical sheet including the first photoconversion layer and the second photoconversion layer, blue light is incident on the first photoconversion layer and the second photoconversion layer, and all of blue light, green light, and red light are emitted through a side opposite to the side on which the blue light is incident, so as to produce white light.

As the first photoconversion layer emitting green light includes a cured product of the quantum dot-containing photosensitive composition according to the present invention, a valley depth representing the depth of the lowest peak between blue light and green light and between green light and red light is very low, indicating excellent color purity.

The photoconversion layer may have any thickness, preferably a thickness of 10 µm to 100 µm, without being limited thereto. If the photoconversion layer is too thick, oxygen or moisture can permeate the optical sheet through side edges thereof and can deteriorate properties of the optical sheet while increasing manufacturing costs, thereby limiting application of the optical sheet to a display device. If the photoconversion layer is too thin, the perovskite quantum dots cannot sufficiently absorb light emitted from a light source, causing deterioration in photoconversion efficiency. Therefore, it is desirable that the photoconversion layer satisfy the above thickness range.

The present invention provides a backlight unit including the quantum dot optical sheet.

The backlight unit (BLU) may include: a quantum dot optical sheet; a light source unit including a light source adapted to generate light; and a light guide plate adapted to guide the light. Here, the backlight unit may further include an optical member and a reflective sheet.

The present invention also provides a display device including the backlight unit. The display device may include a liquid crystal display (LCD), an electroluminescent (EL) display, a plasma display panel (PDP), a field emission display (FED), an organic light emitting diode display (OLED), and the like, without being limited thereto.

### [Mode for Invention]

Next, the present invention will be described in more detail with reference to some examples. It should be understood that these examples are provided for illustration only and are not to be construed in any way as limiting the invention.

### <EXAMPLES>

### Preparative Example: Preparation of perovskite quantum dot dispersion

To 200 mL of 1-octadecene (ODE) in which 2.76 g (7.5 mmol) of PbBr₂ was dissolved, 20 mL of oleic acid (OA) and 20 mL of oleylamine (OLA) were mixed and kept at 120°C under vacuum for 1 hour. Then, Cs-Oleate (reaction product of 0.34 g (1.1 mmol) of Cs₂CO₃, 12.7 mL of ODE, and 3.3 mL of OA) was added to the resulting mixture at a high temperature of 180°C under a N₂ atmosphere and reacted for 5 seconds, followed by quickly cooling to room temperature, thereby preparing CsPbBr₃ perovskite quantum dots.

After centrifugation of a solution containing the CsPbBr₃ perovskite quantum dots, the resulting precipitate was dispersed in toluene. Ethyl acetate was added to the dispersion in a ratio of 1:1, followed by purification through centrifugation and redispersion in toluene. A solution of perovskite quantum dots (6.25 mg/ml) dispersed in toluene was mixed with a ligand solution (0.12 g (6 mmol) of DDAB and 10 mL of toluene) to allow a ligand exchange reaction.

Ethyl acetate was added to the ligand-exchanged perovskite quantum dot solution in a 1:1 ratio and purified through centrifugation. The separated supernatant was removed and the precipitated CsPbBr₃ perovskite green quantum dots were dispersed in 5 mL of dicyclopentanyl acrylate at a concentration of 5 wt%, thereby preparing a perovskite quantum dot dispersion.

### Examples 1 and 2 and Comparative Examples 1 to 7: Preparation of quantum dot-containing photosensitive composition

Perovskite quantum dot-containing photosensitive compositions were prepared as listed in Table 1.

**[Table 1]**

| (Unit: parts by weight) | | Example | | Comparative Example | | | | | | |
|---|---|---|---|---|---|---|---|---|---|---|
| | | 1 | 2 | 1 | 2 | 3 | 4 | 5 | 6 | 7 |
| Quantum dot dispersion | A-1 | 10 | 10 | 10 | 10 | 10 | 10 | 10 | 10 | 10 |
| Monomer | B-1 | 60 | - | 63 | 60 | 60 | 60 | - | - | - |
| | B-2 | 26 | 26 | 26 | 26 | 26 | 26 | 26 | 26 | 38 |
| | B-3 | - | 30 | - | - | - | - | 30 | 30 | 40 |
| | B-4 | - | 30 | - | - | - | - | 30 | 30 | 10 |
| Photoinitiator | C-1 | 1 | 1 | 1 | 1 | 1 | 1 | 1 | 1 | 1 |
| Light diffusing agent | D-1 | 3 | 3 | - | - | - | - | - | - | - |
| | d-1 | - | - | - | 3 | - | - | 3 | - | 1 |
| | d-2 | - | - | - | - | 3 | - | - | - | - |
| | d-3 | - | - | - | - | - | 3 | - | - | - |
| | d-4 | - | - | - | - | - | - | - | 3 | - |

| | | | | | | | | | | |
|---|---|---|---|---|---|---|---|---|---|---|
| A-1: Perovskite quantum dot dispersion prepared in Preparative Example B-1: Dicyclopentanyl acrylate B-2: Ethoxylated bisphenol A diacrylate B-3: Dipentaerythritol pentaacrylate B-4: Pentaerythritol tetrakis(3-mercaptopropionate) C-1: Diphenyl (2,4,6-trimethylbenzoyl)phosphine oxide D-1: Hexagonal boron nitride (h-BN) d-1: ZnO (zinc oxide) d-2: SiO₂ (silicon dioxide) d-3: Al₂O₃ (aluminum oxide) d-4: TiO₂ (titanium dioxide) | | | | | | | | | | |

### <Experimental Example>

### 1. Preparation and evaluation of green quantum dot optical sheet

A green quantum dot optical sheet was prepared by depositing each of the quantum dot-containing photosensitive compositions prepared in Examples and Comparative Examples to a thickness of 46 µm between two sheets of gas barrier substrate films (DNP, thickness 98 µm), followed by curing through UV irradiation at a dose of 80 mJ/cm² for 4 seconds.

### 2. Evaluation of luminance and color coordinate characteristics of green quantum dot optical sheet

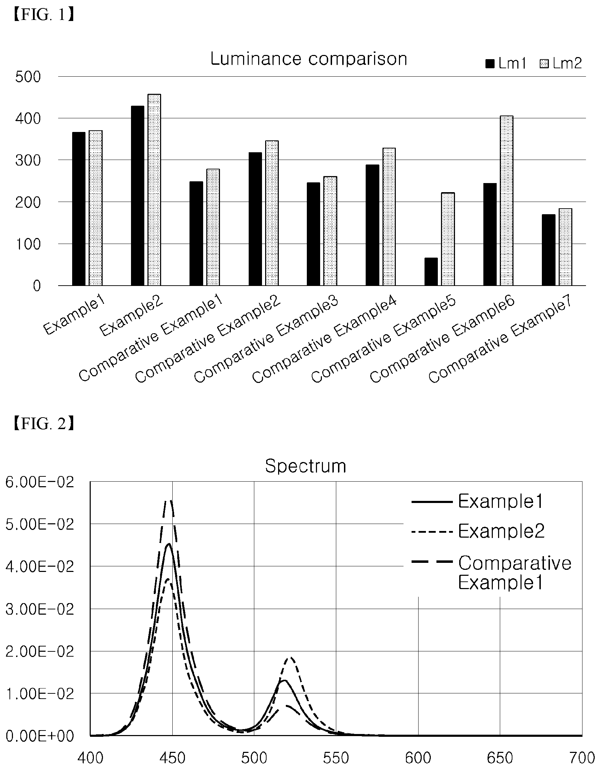

Initial luminance (Lm) and color coordinates (Cx, Cy) of each of the quantum dot optical sheets prepared above were measured using an integrating sphere (Neolight IS500, PIMACS), followed by measuring luminance (Lm) and color coordinates (Cx, Cy) after being exposed to blue light having a wavelength of 450 nm for 70 hours. Based on the obtained data, the luminance retention rate (ΔLm), x-axis color coordinate change (ΔCx), and y-axis color coordinate change (ΔCy) were calculated according to Equations 1 to 3, and results are shown in FIG. 1 and Table 2. [Equation 1] $ΔLm \left(%\right) = \frac{{Lm}_{2}}{{Lm}_{1}} \times 100$

In Equation 1,
Lm₁ denotes an initial luminance value of the quantum dot optical sheet, and
Lm₂ denotes a luminance value of the quantum dot optical sheet, as measured at a certain point in time after the quantum dot optical sheet is exposed to light at a wavelength of 450 nm.
[Equation 2] $ΔCx = {Cx}_{2} - {Cx}_{1}$ [Equation 3] $ΔCy = {Cy}_{2} - {Cy}_{1}$

In Equations 2 and 3,
Cx₁ and Cy₁ denote the initial color coordinates of the quantum dot optical sheet, and
Cx₂ and Cy₂ denote the color coordinates of the quantum dot optical sheet, as measured at a certain point in time after the quantum dot optical sheet is exposed to light at a wavelength of 450 nm.

**[Table 2]**

| | Initial | | | After exposure for 70 hours | | | | | |
|---|---|---|---|---|---|---|---|---|---|
| | Lm₁ | Cx₁ | Cy₁ | Lm₂ | Cx₂ | Cy₂ | ΔLm | ΔCx | ΔCy |
| Example 1 | 366 | 0.152 | 0.114 | 371 | 0.151 | 0.112 | 101% | -0.001 | -0.002 |
| Example 2 | 430 | 0.153 | 0.159 | 458 | 0.152 | 0.165 | 107% | 0.000 | 0.006 |
| Comparative Example 1 | 247 | 0.155 | 0.069 | 278 | 0.154 | 0.075 | 112% | -0.001 | 0.006 |
| Comparative Example 2 | 317 | 0.152 | 0.106 | 347 | 0.151 | 0.111 | 109% | -0.002 | 0.004 |
| Comparative Example 3 | 247 | 0.155 | 0.069 | 260 | 0.154 | 0.070 | 105% | -0.001 | 0.001 |
| Comparative Example 4 | 289 | 0.154 | 0.086 | 328 | 0.152 | 0.094 | 114% | -0.001 | 0.007 |
| Comparative Example 5 | 66 | 0.158 | 0.045 | 221 | 0.154 | 0.120 | 336% | -0.004 | 0.075 |
| Comparative Example 6 | 245 | 0.154 | 0.144 | 406 | 0.151 | 0.210 | 166% | -0.002 | 0.065 |
| Comparative Example 7 | 169 | 0.156 | 0.075 | 184 | 0.156 | 0.078 | 109% | 0.000 | 0.003 |

Referring to FIG. 1 and Table 2, it can be seen that the quantum dot optical sheets prepared using the quantum dot-containing photosensitive compositions of Examples 1 and 2 had an initial luminance (Lm₁) of 350 lm or more, indicating significant improvement compared to Comparative Examples, did not suffer from degradation in luminance, and had color coordinate changes within ±0.006 even after being exposed to blue light for 70 hours, indicating excellent photostability. Conversely, it can be seen that all of the quantum dot optical sheets prepared using the quantum dot-containing photosensitive compositions of Comparative Examples 1 to 7 had an initial luminance (Lm1) of less than 350 lm and suffered from a significant luminance change and significant color coordinate changes after being exposed to blue light for 70 hours. In particular, the quantum dot optical sheets prepared using the quantum dot-containing photosensitive compositions of Comparative Examples 5 and 6 exhibited a luminance increase of 160% or more after being exposed to light for 70 hours. Such a significant change in luminance can cause degradation of a display quality.

### 3. Emission spectrum analysis of green quantum dot optical sheet

For the quantum dot optical sheets prepared using the quantum dot-containing photosensitive compositions of Examples 1, 2 and Comparative Example 1, the maximum emission wavelength and the full width at half maximum (FWHM) were measured through emission spectrum analysis after irradiation with blue light (LED, 448 nm) for 70 hours using an integrating sphere (Neolight IS500, PIMACS), and results are shown in FIG. 2 and Table 3.

**[Table 3]**

| | Blue light | | Green quantum dot optical sheet | |
|---|---|---|---|---|
| | Light source | Wavelength (nm) | Maximum emission wavelength (nm) | FWHM (nm) |
| Example 1 | LED | 448 | 519 | 21 |
| Example 2 | LED | 448 | 522 | 20 |
| Comparative Example 1 | LED | 448 | 519 | 24 |

Referring to FIG. 2 and Table 3, it can be seen that the quantum dot optical sheets prepared using the quantum dot-containing photosensitive composition of Examples 1 and 2 had a full width at half maximum of 20 nm to 21 nm in the green emission wavelength, which is narrower than a full width at half maximum of 24 nm in Comparative Example 1. Accordingly, it is believed that the quantum dot optical sheets prepared using the quantum dot-containing photosensitive compositions of Examples 1 and 2 will provide improved color reproducibility in green color.

### Example 3

### 1. Preparation of green-red quantum dot optical sheet

1) An InP-based red quantum dot-containing photosensitive composition was prepared using the same ingredients as in Example 1 except that a red quantum dot dispersion prepared by dispersing InZnP/ZnSe/ZnS (core/shell/shell) quantum dots in 1,6-hexanediol diacrylate was used instead of the perovskite quantum dot dispersion prepared in Preparative Example 1.
2) A first photoconversion layer (green photoconversion layer) was formed by depositing the quantum dot-containing photosensitive composition prepared in Example 1 to a thickness of 46 µm on a gas barrier base film (DNP, thickness 98 µm), followed by curing through UV irradiation at a dose of 80 mJ/cm² for 4 seconds.
3) A second photoconversion layer (red photoconversion layer) was formed by depositing the InP-based red quantum dot-containing photosensitive composition to a thickness of 46 µm on a separate gas barrier base film (DNP, thickness 98 µm), followed by curing through UV irradiation at a dose of 80 mJ/cm² for 4 seconds.
4) A green-red quantum dot optical sheet was prepared by stacking the first and second photoconversion layers so that they were in contact with each other.

### 2. Evaluation of optical properties of green-red quantum dot optical sheet

Initial luminance (Lm) and color coordinates (Cx, Cy) of the green-red quantum dot optical sheet were measured using an integrating sphere (Neolight IS500, PIMACS), followed by measuring luminance (Lm) and color coordinates (Cx, Cy) upon exposure to blue light having a wavelength of 450 nm for 70 hours.

In addition, for the green-red quantum dot optical sheet prepared above, the maximum emission wavelength and the full width at half maximum (FWHM) were measured through emission spectrum analysis after irradiation with blue light (LED, 448 nm) for 70 hours using an integrating sphere (Neolight IS500, PIMACS), and the valley depth was calculated according to Equation 4.

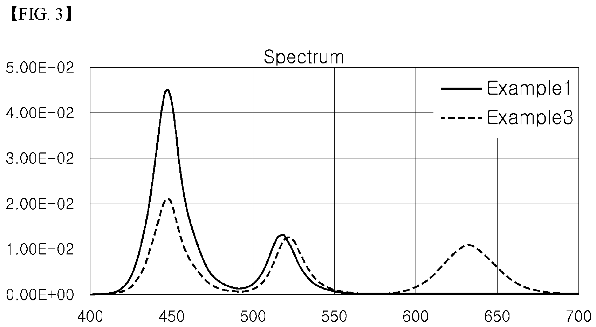

The measured and calculated results are shown in FIG. 3 and Table 4. [Formula 4] $Valley depth \left(%\right) = \frac{Min peak}{Max peak 1 + Max peak 2} \times 100$

In Equation 4,
Max peak1 denotes a peak value at the green maximum emission wavelength,
Max peak2 denotes a peak value at the red maximum emission wavelength, and
Min peak denotes a peak value at the minimum emission wavelength between the green maximum emission wavelength and the red maximum emission wavelength.

**[Table 4]**

| | Initial | | | After exposure for 70 hours | | | | | | | |
|---|---|---|---|---|---|---|---|---|---|---|---|
| | Lm₁ | Cx₁ | Cy₁ | Lm₂ | Cx₂ | Cy₂ | λmax-G (nm) | FWHM-G (nm) | λmax-R (nm) | FWHM-R (nm) | Valley depth (%) |
| Example 1 | 366 | 0.152 | 0.114 | 371 | 0.151 | 0.112 | 519 | 21 | - | - | - |
| Example 3 | 433 | 0.253 | 0.205 | 519 | 0.270 | 0.223 | 522 | 22 | 632 | 39 | 0.67 |

Referring to FIG. 3 and Table 4, it can be seen that the green-red quantum dot optical sheet prepared in Example 3 had an initial luminance (Lm₁) of 433 lm and a luminance of 519 lm after exposure to blue light for 70 hours, indicating excellent luminance characteristics.

In addition, it can be seen that, in Example 3, despite contact between the green photoconversion layer containing the perovskite quantum dots and the red photoconversion layer containing the InP-based red quantum dots, the maximum emission wavelength in the green region was shifted by 3 nm toward a longer wavelength, as compared to Example 1, and the full width at half maximum was similar to that of Example 1. From this result, it can be seen that the perovskite quantum dots can exhibit stable optical properties without degradation, despite contact between the two photoconversion layers. It can also be seen that the valley depth between the green peak emission wavelength and the red peak emission wavelength was 0.67%, indicating very good color purity to be applied to high definition displays.

It is believed that these results are attributed to chemical stability and wide bandgap (5.5 eV to 6.0 eV) of hexagonal boron nitride (h-BN), which allows stable protection of the structure of perovskite quantum dots (CsPbBr₃) without collapse of the structure by providing low light absorption or heat generation under 448 nm to 450 nm blue light conditions.

## Claims

1. A quantum dot-containing photosensitive composition comprising: perovskite quantum dots; a photopolymerizable monomer; a photoinitiator; and a light diffusing agent, wherein the light diffusing agent comprises boron nitride (BN).

2. The quantum dot-containing photosensitive composition according to claim 1, wherein the perovskite quantum dots are halide-based perovskite quantum dots.

3. The quantum dot-containing photosensitive composition according to claim 2, wherein the halide-based perovskite quantum dots are a compound represented by Formula 1.
[Formula 1] ABX₃
(In Formula 1,
A is formamidinium (FA), methyl ammonium (MA), FA_{X}MA_{(1-X)} (0<X<1), N⁺(R¹)₄, Na, K, Rb, Cs, Fr, or Ti,
R¹ is a C₁ to C₅ alkyl group, phenyl group, alkylphenyl group, or alkoxyphenyl group;
B is Pb, Mn, Cu, Ga, Ge, In, Al, Sb, Bi, Po, Sn, Eu, Yb, Ni, Co, Fe, Cr, Pd, Cd, Ca, or Sr; and
X is F, Cl, Br, I, or a combination thereof).

4. The quantum dot-containing photosensitive composition according to claim 1, wherein the perovskite quantum dots have a ligand layer on a surface thereof,
the ligand layer comprising at least one selected from the group consisting of an amine-based ligand, an organic acid-based ligand, and an organoammonium-based ligand.

5. The quantum dot-containing photosensitive composition according to claim 1, wherein the photopolymerizable monomer comprises at least one selected from the group consisting of a bisphenol-based monomer, a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

6. The quantum dot-containing photosensitive composition according to claim 5, wherein the photopolymerizable monomer comprises: a bisphenol-based monomer; and at least one selected from the group consisting of a monofunctional (meth)acrylate monomer, a bifunctional (meth)acrylate monomer, a trifunctional (meth)acrylate monomer, a tetra- or higher functional (meth)acrylate monomer, an alicyclic (meth)acrylate monomer, and a monomer having at least two thiol groups at terminal ends thereof.

7. The quantum dot-containing photosensitive composition according to claim 1, wherein the boron nitride is hexagonal boron nitride.

8. The quantum dot-containing photosensitive composition according to claim 1, wherein the light diffusing agent is present in an amount of 0.5 wt% to 10 wt%, based on the total weight of the quantum dot-containing photosensitive composition.

9. A quantum dot optical sheet comprising a cured product of the quantum dot-containing photosensitive composition according to any one of claims 1 to 8.

10. A backlight unit comprising the quantum dot optical sheet according to claim 9.

11. A display device comprising the backlight unit according to claim 10.
